# EUROPÄISCHE PATENTSCHRIFT

(11) **EP 1 372 837 B1**
(45) Veröffentlichungstag und Bekanntmachung des Hinweises auf die Patenterteilung: **07.03.2007**
(21) Anmeldenummer: 02702202.9
(22) Anmeldetag: 21.03.2002
(51) Int. Cl.: B01J 3/00, C30B 29/16, C30B 15/00

(54) **VERWENDUNG VON STABILISIERTEM ZIRKONIUMOXID MONOKRISTALL FüR SICHTFENSTER**
APPLICATION OF STABILIZED ZIRCONIUM OXIDE SINGLE CRYSTAL FOR OBSERVATION WINDOW
APPLICATION D'OXYDE DE ZIRCONIUM MONOCRISTALLIN STABILISÉ DANS DES FENÊTRES D'OBSERVATION

(30) Priorität: 03.04.2001 CH 621012001
(43) Veröffentlichungstag der Anmeldung: 02.01.2004
(73) Patentinhaber: PAUL SCHERRER INSTITUT, 5232 Villigen PSI (CH)
(72) Erfinder: DEGUELDRE, Claude, A., CH-5200 Brugg (CH)
(74) Vertreter: Fischer, Michael
(86) Internationale Anmeldenummer: PCT/CH2002/000170
(87) Internationale Veröffentlichungsnummer: WO 2002/081073

(56) Entgegenhaltungen:
- WO-A-82/03876
- US-A- 4 153 469
- US-A- 5 036 767
- US-A- 5 046 854
- US-A- 5 358 645
- US-A- 5 769 540
- US-A- 5 949 536
- US-A- 6 103 934

## Beschreibung

Die vorliegende Erfindung betrifft die Verwendung von stabilisiertem Zirkoniumoxid-Monokristall für Sichtfenster bei chemischen Reaktoren, Autoklaven, Boilern, bei Nuklearreaktoren, insbesondere Siedewasserreaktoren etc., d.h. bei geschlossenen Behältnissen, in welchen Prozesse bei extremen Bedingungen wie erhöhter Temperatur, hohem Druck, in saurem oder basischem bzw. oxidierendem oder reduzierendem Milieu etc. durchgeführt werden. Im weiteren betrifft die vorliegende Erfindung Sichtfenster für chemische Reaktoren, Autoklaven, Boiler, Nuklearreaktoren etc. sowie Überwachungs-, Steuerungs- und Analyseverfahren unter Verwendung eines erfindungsgemässen Beobachtungs- bzw. Sichtfensters.

Für die In-Situ-Überwachung von Reaktionsprozessen in Reaktionsgefässen, wie insbesondere Autoklaven, Siedewasser/Druckwasser-Reaktoren und dergleichen, sind Sichtfenster vorgesehen, deren Fenstermaterial entsprechend den Anforderungen zu wählen ist. Bei der Messung und Überwachung von klassischen und unter extremen Bedingungen stattfindenden Reaktionen, d.h. unterhalb oder oberhalb thermodynamisch kritischer Bedingungen von Flüssigkeiten, von korrosiven Lösungen (saure oder basische, reduktive oder oxidierende Bedingungen) für die Feststellung des Fortschrittes von Reaktionen oder von strukturellen Änderungen in industriellen, chemischen oder nuklearen Einrichtungen ergeben sich erhöhte Anforderungen an das für Sichtfenster zu wählende Material. Gewöhnliches Glas kann bei Reaktoren bei Raumtemperatur oder nur leicht erhöhten Temperaturen sowie nicht aggressiven atmosphärischen Bedingungen genügen, falls einwandfreie Transparenz eines genannten Sichtfensters für die Überwachung des Reaktionsprozesses nicht über längere Zeit gefragt ist. Im Falle, dass der Reaktionsprozess beispielsweise mittels spektroskopischer Methoden zu überwachen ist, ist gewöhnlich Glas wie Quarz oder Saphir oft nicht das geeignete Material. Im Falle, dass Prozesse, wie insbesondere Reaktionsprozesse, bei hohen Temperaturen, hohen Drücken und aggressiven atmosphärischen Bedingungen durchgeführt werden und eine Prozesssteuerung bzw. -überwachung unter Zuhilfenahme von optischen oder anderen, analytischen Methoden gefordert ist, ist entsprechend ein geeignetes Material zu wählen, welches den Anforderungen an Transparenz entspricht.

So wird z.B. bei Siedewasser-Reaktor-Bedingungen zur Überwachung der Korrosion des für das Reaktorgehäuse verwendeten rostfreien Stahles wie beispielsweise einer Zirkonialegierung (Zircaloy) mittels Diffusions-Reflexions-Spektroskopie (DRS) vorgeschlagen, ein Sichtfenster aus Saphirglas zu verwenden, d.h. bestehend aus α-Aluminiumoxid (künstlicher Saphir). Dieses Material bleibt auch bei erhöhten Temperaturen über eine verlängerte Zeitspanne transparent und ist kommerziell zu einem akzeptablen Preis erhältlich.

Die Verwendung von Saphirfenstern für die Überwachung von insbesondere Reaktionsphänomenen wird in einer Anzahl von Patentschriften beschrieben, wie insbesondere in den beiden US-Patenten US 4 666 251 und US 5 709 471 sowie in den beiden japanischen Patentschriften JP 4 001 709 A2 und JP 6 318 647 A2.

So hat es sich gezeigt, dass Saphirfenster selbst bei Siedewasserbedingungen transparent bleiben, jedoch beispielsweise nach 20 Tagen Kontakt mit Heisswasser ihre Durchsichtigkeit verlieren.

Weiter wurde festgestellt, dass bei erhöhter chemischer Aggressivität wie in sauren oder basischen Bedingungen bzw. in reduzierender oder oxidierender Umgebung und bei noch höheren Temperaturen als Siedetemperatur des Wassers Saphir eine geringe Oberflächenlöslichkeit aufweist, was zur Verminderung der Transparenz führt.

Es ist daher eine Aufgabe der vorliegenden Erfindung, ein Material für Sichtfenster der beschriebenen Art zu finden, welches bei erhöhter Temperatur und den erwähnten, erhöht extremen Umgebungsbedingungen transparent bleibt.

Erfindungsgemäss wird die Verwendung von von stabilisiertem Zirkoniumoxid monokristall gemäss dem Wortlaut nach Anspruch 1 vorgeschlagen.

Es hat sich gezeigt, dass durch die Verwendung von stabilisiertem Zirkoniumoxid-Monokristall bzw. Zirkonia Sichtfenster in Reaktionsgefässen, Autoklaven, Boilern, Nuklearreaktoren, wie insbesondere in Siedewasserreaktoren, hergestellt werden können, welche auch bei erhöhten Temperaturen, erhöhtem Druck und/oder extremen Bedingungen wie saurem oder basischem Milieu, oxidierendem oder reduzierendem Milieu während einer verlängerten Zeitspanne transparent bleiben.

Die Verwendung von Zirkonia für andere Anwendungen ist an sich bekannt. So wird beispielsweise im US 5 036 767 kubisches Zirkonia für optische Fenster von Laser-injizierten explosiven Einrichtungen vorgeschlagen. Im US 5 949 536 wird die Verwendung von kubischem Zirkonia für optische Zellen im Zusammenhang mit spektroskopischen Analysegeräten vorgeschlagen. Als weitere geeignete Materialien werden in dieser US-Patentschrift solche vorgeschlagen, welche für die Verwendung von Sichtfenstern in Reaktionsgefässen, wie in der vorliegenden Erfindung vorgeschlagen, in keiner Weise geeignet sind. Im US Patent 5 769 540 wiederum wird eine Zirkoniabeschichtung auf einem Substrat vorgeschlagen im Zusammenhang mit optischen Verfahren für das Messen von Oberflächenbeschaffenheiten. Mit demselben Anwendungsgebiet befasst sich das US Patent 5 490 728. In keiner dieser genannten Patentschriften aber wird Zirkonia bzw. stabilisierter Zirkoniumoxid-Monokristall im Zusammenhang mit der Verwendung von Sichtfenstern in Reaktionsgefässen, Autoklaven, Boiler und dgl., wie in der vorliegenden Erfindung beschrieben, erwähnt noch nahegelegt.

Vorzugsweise wird ein Zirkoniumoxidmaterial für die Herstellung der erwähnten Sichtfenster verwendet, welches stabilisiert ist mit Kalzium, Magnesium oder Yttrium.

Die Reinheit von stabilisiertem Zirkonia muss besser als 98 % sein.

Der Anteil an chromatischen Verunreinigungen sollte so niedrig wie möglich sein und hängt von der Art und der Anwendung des Sichtfensters ab.

Die Oberflächenrauheit des mittels stabilisiertem Zirkonia hergestellten Fensters muss so klein wie möglich sein und bewegt sich normalerweise im Nanometer-Bereich, wiederum abhängig von der Anwendung. So beträgt beispielsweise die Oberflächenrauheit eines erwähnten Sichtfensters im Durchschnitt ca. 1 nm und sollte in jedem Falle < 3 nm sein.

Ein bevorzugtes Material für die Herstellung der erwähnten Sichtfenster ist Yttrium-, Kalzium- oder Magnesium-stabilisiertes Zirkoniumoxid bzw. Zirkonia, wobei der Anteil am kubischen Monokristallmaterial ungefähr 90 mol% Zirkoniumoxid beträgt. Anstelle von Yttrium kann auch ein anderes transparentes Element der (schweren) Lanthanoiden verwendet werden.

Das nachfolgende Beispiel eines Yttrium-kubisch-stabilisierten Zirkoniumoxid-Fensters soll für das bessere Verständnis der vorliegenden Erfindung dienen:

| **Parameter** | **Wert / Einheit** |
|---|---|
| Formel | Y_{0,15} Zr_{0,85}O_{1,925} |
| Struktur | Mono-Kristallin |
| Reinheit | > 98 % |
| Transparenz | Von 300* bis 2000 nm (oder besser) |
| Dichte | 6,0 g cm⁻³ |
| Härte | 1100 - 1500 kg mm⁻² |
| Impuls-Festigkeit | 69 - 105 kg mm⁻² |
| Wärmekapazität | 460 J kg⁻¹ K⁻¹ |
| Wärmeleitfähigkeit | ~ 2,0 W m⁻¹ K⁻¹ |
| Wärmeausdehnung | 10,3 x 10⁻⁶ K⁻¹ |
| Refraktionsindex n | 2,10 |
| dn/dT | 7,9 x 10⁻⁶ K⁻¹ |
| Säureresistenz | extrem hoch |
| Löslichkeit bei pH 1 | 2 x 10⁻⁵ M |
| Wasserbeständigkeit | Inert |
| Löslichkeit in Wasser | ~10⁻¹⁰ M |
| Korrosionsrate in bidestilliertem Wasser bei 300°C | 90 ng cm⁻²h⁻¹ 1) |
| Basenresistenz | extrem hoch |
| Löslichkeit bei pH 13 | 2 x 10⁻⁵. M |

| | |
|---|---|
| * abhängig von der chromatischen Verunreinigungs-Konzentration 1) Zum Vergleich: Korrosionsrate von Saphir: 7100 ng cm⁻²h⁻¹ Korrosionsrate von Glas (Vycor) : 31000 ng cm⁻² h⁻¹ (bei gleichen Bedingungen) | |

Für die Überwachung von beispielsweise Reaktionsprozessen oder der oben erwähnten Korrosion in Siedewasserreaktoren kann ein einziges Fenster aus stabilisiertem Zirkoniumoxidmonokristall bzw. Zirkonia verwendet werden, indem die für die Überwachung verwendete analytische Methode in einem sogenannten reflektiven Modus betrieben wird. Das heisst, der durch das Fenster in das zu überwachende Medium eingeführte Strahl wird an der zum Fenster gegenüberliegenden Wandung des Prozess-Gehäuses reflektiert und tritt durch dasselbe erwähnte Fenster aus optisch stabilisiertem Zirkoniumoxid bzw. Zirkonia für die analytische Auswertung wieder aus.

Anhand der beigefügten Figur soll die erfindungsgemässe Verwendung eines Zirkoniumoxid-Fensters für die Überwachung eines Prozesses gemäss der vorliegenden Erfindung näher erläutert werden.

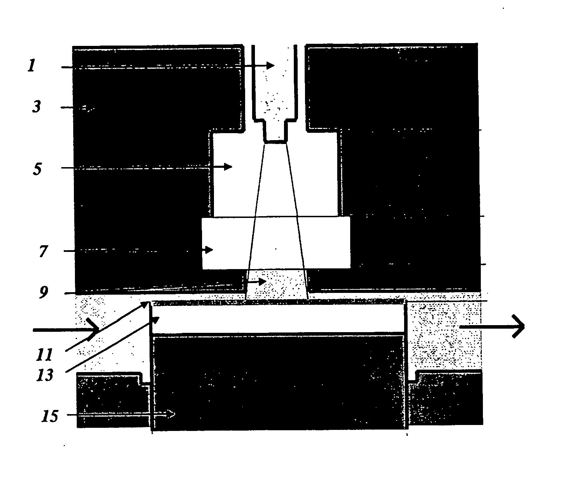

Fig. 1 zeigt im Schnitt schematisch eine Versuchs anordnung gemäss der vorliegenden Erfindung. Das Schema zeigt eine Versuchsanordnung, ausgestattet mit einem optisch stabilisierten Zirkoniumoxid-Fenster für die Durchführung einer Prozessüberwachung im sogenannten reflektiven Modus.

Eine Messzelle resp. Messprobe 1 ist vorgesehen, wie beispielsweise ein optisches Fasersystem, welches mit spektroskopischen oder optischen Messquellen verbunden ist, wie beispielsweise einem Spektrometer oder einer Videokamera sowie mit einer Auswerteinheit. Die Messzelle ist eingelassen in einem Behältnis aus Metall, wie beispielsweise rostfreiem Stahl oder Inert-Keramik.

Das von der Messzelle emittierte Signal verläuft zunächst durch eine Luftkammer 5 und anschliessend durch das erfindungsgemäss vorgeschlagene optisch stabilisierte Zirkoniumoxid-Fenster 7. Auf der Rückseite des Zirkoniumoxid-Fensters befindet sich der Raum mit der beispielsweise zu untersuchenden bzw. analytisch zu überwachenden Flüssigkeit 9, bei welcher es sich beispielsweise um heisses Wasser oder um eine korrosive oder reaktive Lösung handeln kann.

Für die analytische Überwachung ist es wesentlich, dass das von der Messprobe abgegebene Signal reflektiert wird, was durch die weitgehendst vollständig reflektive Oberfläche 11 erfolgt.

Da es vorteilhaft bzw. lediglich notwendig ist, dass nur ein Teil der zu überwachenden Flüssigkeit on line analysiert wird, bewegt sich der Grossteil der zu untersuchenden Flüssigkeit 13 entlang der Rückseite der reflektierenden Oberfläche 11. Schliesslich abgeschlossen wird die Messanordnung durch eine rückseitige Wandung 15.

Das Überwachen eines Prozesses ist selbstverständlich nicht beschränkt auf die Verwendung nur eines Sichtfensters aus stabilisiertem Zirkoniumoxid, sondern es ist auch möglich, erwähnte Sichtfenster in Serie für die Überwachung zu verwenden, indem der für die Überwachung verwendete Strahl mittels Transmission durch die erwähnte Einheit, wie einen Reaktor, Autoklaven, Siedewasser-/Druckwasserreaktor, Heizkessel, Boiler etc., hindurchgeführt wird.

Das optisch stabilisierte Zirkoniumoxid-Fenster kann beispielsweise gegenüber der Reaktorwandung bzw. Autoklavwandung etc. mittels Teflon, Kohlenstoffgraphit, Gummi oder mittels eines weichen Metallringes abgedichtet bzw. gegenüber der Behältniswandung eingepresst werden. Die Abdichtung kann auch wie in der US 5 046 854 vorgeschlagen erfolgen.

Aufgrund der hohen Festigkeit und der Inertheit des stabilisierten Zirkoniafensters kann dieses sowohl für die Überwachung von Wasser, sauren oder basischen Lösungen, organischen Lösungen verwendet werden, wie auch für die Überwachung von Prozessen, welche bei erhöhten Temperaturen durchgeführt werden, wie beispielsweise im Bereich zwischen 200 und 1000 Kelvin, sowie bei Vorgängen unter Druck in einem Bereich von z.B. 1 - mindestens 500 atm.

Die optische Transparenz bleibt in einem Spektralbereich von mindestens 300 - 2000 nm oder besser konstant, insbesondere in Kontakt mit transparenten Flüssigkeiten und erhöhter Temperatur von weit über 500 Kelvin, selbst bei Verwendung von Neutronen- oder Gammastrahlung.

Wie der Korrosionsvergleich von stabilisiertem Zirkoniumoxid, Saphir und Glas im vorangehenden Beispiel bei gleichen Bedingungen zeigt, ist die Korrosion von stabilisiertem Zirkoniumoxid wesentlich geringer als diejenige von Saphir und von Glas. Diese geringere Korrosivität ergibt sich aus der wesentlich geringeren Oberflächenlöslichkeit von kubisch stabilisiertem Zirkoniumoxid, verglichen mit der Löslichkeit von Saphir oder Glas.

Stabilisierte Zirkoniafenster können für die Überwachung während Wochen, Monaten oder gar während Jahren verwendet werden, wobei die Verwendungszeitdauer selbstverständlich abhängig ist vom zu überwachenden System und von den Anforderungen an die Transparenz des Fensters.

Ein Sichtfenster aus stabilisiertem Zirkoniumoxid der erfindungsgemäss definierten Art kann für die optische Überwachung verwendet werden unter Verwendung von photographischen Geräten, Videoüberwachungen, wie auch für spektroskopische Überwachungen im UV-, visuellen wie auch im Infrarot-Bereich.

Die Dimensionen des zu verwendenden Zirkoniumoxid-Fensters richten sich selbstverständlich an die Anforderungen, wie insbesondere an die mechanischen Anforderungen, aufgrund der im Reaktionsgefäss, Autoklaven etc. herrschenden Prozess- bzw. Reaktionsbedingungen.

Schliesslich sei noch darauf hingewiesen, dass der Preis von stabilisiertem Zirkoniumoxid, wie erfindungsgemäss vorgeschlagen, nicht höher ist als der Preis von Saphir. Im Gegenteil, stabilisiertes Zirkoniumoxid wird preislich wesentlich günstiger angeboten als beispielsweise Diamant. Stellvertretend für eine Reihe von Anbietern sei die Firma Mateck - Material-Technologie und Kristalle GmbH, Dr. H. Schlich in D-52428 Jülich, erwähnt.

## Patentansprüche

1. Verwendung von stabilisiertem Zirkoniumoxidmonokristall für Sichtfenster in Reaktionsgefässen, Autoklaven, Boilern, nuklearen Reaktoren wie Siedewasserreaktoren.

2. Verwendung nach Anspruch 1, **dadurch gekennzeichnet, dass** mit Kalzium, Magnesium oder Yttrium stabilisiertes Zirkoniumoxid verwendet wird.

3. Verwendung nach einem der Ansprüche 1 oder 2, **dadurch gekennzeichnet, dass** die Reinheit vom kubisch stabilisierten Zirkoniumoxid mindestens 98 %, vorzugsweise > 99 % ist.

4. Verwendung nach einem der Ansprüche 1 bis 3, **dadurch gekennzeichnet, dass** das kubisch stabilisierte Zirkoniumoxid bzw. Zirkonia mittels Yttrium oder einem anderen transparenten Element der schweren Lanthanoiden stabilisiert ist.

5. Verwendung nach einem der Ansprüche 1 bis 4, **dadurch gekennzeichnet, dass** der stabilisierte Zirkoniamonokristall ungefähr 90 mol% Zirkoniumdioxid aufweist.

6. Verwendung nach einem der Ansprüche 1 bis 5, **dadurch gekennzeichnet, dass** das stabilisierte Zirkoniumoxid bzw. Zirkonia die nachfolgende Formel aufweist:
Y_{0,15} Zr_{0,85} O_{1,925}

7. Sichtfenster in Reaktionsgefässen, Autoklaven, Boilern, Nuklearreaktoren, Siedewasser- oder Druckwasserreaktoren **dadurch gekennzeichnet, dass** das Fenster aus stabilisiertem Zirkoniumoxidmonokristall besteht.

8. Sichtfenster, insbesondere nach Anspruch 7, **dadurch gekennzeichnet, dass** das kubisch stabilisierte Zirkoniumoxidfenster mit PTFE (Teflon), Kohlenstoffgraphit, Gummi oder einem Weichmetallring in die Behältniswandung eingelassen bzw. gegenüber dieser abgedichtet ist.

9. Sichtfenster nach einem der Ansprüche 7 oder 8, **dadurch gekennzeichnet, dass** mit Kalzium, Magnesium, Yttrium oder einem anderen transparenten Element der schweren Lanthanoiden stabilisiertes Zirkoniumoxid als stabilisierter Zirkoniumoxidmonokristall verwendet wird.

10. Verwendung des Sichtfensters nach einem der Ansprüche 7 bis 9 für die In-Situ-Prozessüberwachung in geschlossenen Gefässen, Reaktionsgefässen, Autoklaven, Boilern, Siedewasserreaktoren wobei die Überwachung entweder optisch mittels fotographischen Geräten oder Videogeräten erfolgt, oder mittels spektroskopischer Methoden.

11. Verwendung nach Anspruch 10, **dadurch gekennzeichnet, dass** die Überwachung mittels reflektivem Modus erfolgt, d.h., dass der durch das Sichtfenster in das Behältnis eingeführte Strahl für die Überwachung des Prozesses an der zum Fenster gegenüberliegenden Wandung des Behältnisses reflektiert und durch das Fenster wieder ausgetragen und für die analytische Auswertung der Überwachung erfasst wird.

12. Verwendung nach Anspruch 10, **dadurch gekennzeichnet, dass** im Behältnis mindestens zwei in Serie angeordnete Sichtfenster nach einem der Ansprüche 7 bis 9 angeordnet sind und die Überwachung mittels Transmission erfolgt.

## Claims

1. Use of stabilized zirconium oxide monocrystal for observation windows in reaction vessels, autoclaves, boilers, nuclear reactors such as boiling-water reactors, and the like.

2. Use according to Claim 1, **characterized in that** zirconium oxide stabilized with calcium, magnesium, or yttrium is used.

3. Use according to one of Claims 1 or 2, **characterized in that** the purity of the cubic stabilized zirconium oxide is at least 98%, preferably > 99%.

4. Use according to one of Claims 1 to 3, **characterized in that** the cubic stabilized zirconium oxide or zirconia is stabilized by yttrium or another transparent element in the heavy lanthanoid series.

5. Use according to one of Claims 1 or 4, **characterized in that** the stabilized zirconia monocrystal contains approximately 90 mol% zirconium dioxide.

6. Use according to one of Claims 1 to 5, **characterized in that** the stabilized zirconium oxide or zirconia has the following formula:
Y_{0.15}Zr_{0.85}O_{1.925}.

7. Observation window in reaction vessels, autoclaves, boilers, nuclear reactors, particularly boiling-water or pressurized-water reactors, and the like, **characterized in that** the window consists at least largely of zirconium oxide or zirconia, particularly of stabilized zirconium oxide monocrystal.

8. Observation window, particularly according to Claim 7, **characterized in that** the cubic stabilized zirconium oxide window is sealed with PTFE (Teflon), carbon graphite, rubber, or a soft metal gasket inserted into the container wall.

9. Observation window according to one of Claims 7 or 8, **characterized in that** zirconium oxide stabilized with calcium, magnesium, yttrium, or another transparent element in the heavy lanthanoid series is used as the stabilized zirconium oxide monocrystal.

10. Use of the observation window according to one of Claims 7 to 9 for in situ process monitoring in closed vessels, particularly in reaction vessels, autoclaves, boilers, boiling water reactors, and the like, with monitoring being conducted either optically using photographic or video apparatus or by spectroscopic methods.

11. Use according to Claim 10, **characterized in that** the monitoring takes place by the reflective mode, i.e. the beam passing through the observation window in the container for monitoring the process is reflected at the wall of the process container opposite the window and exits through the same window, and is picked up for analytical evaluation.

12. Use according to Claim 10, **characterized in that** at least two observation windows according to one of Claims 7 to 9 are arranged in series in the container and monitoring takes place by transmission.

## Revendications

1. Utilisation de monocristal d'oxyde de zirconium stabilisé pour des hublots dans des récipients de réaction, des autoclaves, des chaudières, des réacteurs nucléaires comme des réacteurs à eau bouillante.

2. Utilisation suivant la revendication 1, **caractérisée en ce que** l'on utilise de l'oxyde de zirconium stabilisé par du calcium, par du magnésium ou par de l'yttrium.

3. Utilisation suivant l'une des revendications 1 ou 2, **caractérisée en ce que** la pureté de l'oxyde de zirconium stabilisé de façon cubique est d'au moins 98 %, de préférence > 99 %.

4. Utilisation suivant l'une des revendications 1 à 3, **caractérisée en ce que** l'oxyde de zirconium ou la zircone stabilisée de façon cubique est stabilisée au moyen d'yttrium ou d'un autre élément transparent des lanthanoïdes lourds.

5. Utilisation suivant l'une des revendications 1 à 4, **caractérisée en ce que** le monocristal de zircone stabilisé contient environ 90 % en mole de dioxyde de zirconium.

6. Utilisation suivant l'une des revendications 1 à 5, **caractérisée en ce que** l'oxyde de zirconium ou la zircone stabilisée a la formule suivante :
Y_{0,15} Zr_{0,85} O_{1,925}.

7. Hublot dans des récipients de réaction, des autoclaves, des chaudières, des réacteurs nucléaires, des réacteurs à eau bouillante ou des réacteurs à eau sous pression, **caractérisé en ce que** le hublot est constitué d'un monocristal d'oxyde de zirconium stabilisé.

8. Hublot, notamment suivant la revendication 7, **caractérisé en ce que** l'hublot en oxyde de zirconium stabilisé de façon cubique est encastré par du PTFE (Téflon), du carbone graphite, du caoutchouc ou une bague en métal tendre dans la paroi du récipient ou est rendu étanche par rapport à celui-ci.

9. Hublot suivant l'une des revendications 7 ou 8, **caractérisé en ce qu'**il est utilisé comme monocristal d'oxyde de zirconium stabilisé de l'oxyde de zirconium stabilisé par du calcium, par du magnésium ou par de l'yttrium ou par un autre élément transparent des lanthanoïdes lourds.

10. Utilisation du hublot suivant l'une des revendications 7 à 9 pour le contrôle de processus in situ dans des récipients fermés, des récipients de réaction, des autoclaves, des chaudières, des réacteurs à eau bouillante, le contrôle s'effectuant soit optiquement au moyen d'appareils photographiques, soit des méthodes spectroscopiques.

11. Utilisation suivant la revendication 10, **caractérisée en ce que** le contrôle s'effectue au moyen d'un mode de réflexion, c'est-à-dire que le rayonnement entrant dans le hublot par la fenêtre pour le contrôle du processus est réfléchi sur la paroi du récipient opposée à la fenêtre et ressort par la fenêtre et est détecté pour l'exploitation analytique du contrôle.

12. Utilisation suivant la revendication 10, **caractérisée en ce qu'**il est monté dans le récipient au moins deux hublots suivant l'une des revendications 7 à 9 montés en série et le contrôle s'effectue au moyen d'une transmission.
